# EUROPEAN PATENT APPLICATION

(11) **EP 3 181 724 A2**
(43) Date of publication of application: **21.06.2017**
(21) Application number: 16202084.6
(22) Date of filing: 02.12.2016
(51) Int. Cl.: C23C 18/20, C23C 18/30, H05K 3/18, H05K 3/42, C23C 18/18

(54) **ENVIRONMENTALLY FRIENDLY STABLE CATALYSTS FOR ELECTROLESS METALLIZATION OF PRINTED CIRCUIT BOARDS AND THROUGH-HOLES**

(30) Priority: 14.12.2015 US 201562266782 P
(71) Applicant: Rohm and Haas Electronic Materials LLC, Marlborough, MA 01752 (US)
(72) Inventor: CLEARY, Donald E., Marlborough, MA Massachusetts 01752 (US)
(74) Representative: Houghton, Mark Phillip

(57) **Abstract**

Catalysts include nanoparticles of catalytic metal and maltodextrin as a stabilizer in molar ratios which enable stabilization of the catalyst during storage and during electroless metal plating. The catalysts are environmentally friendly and are tin free. The catalysts adhere well to dielectric materials of printed circuit boards including the walls of through-holes.

## Description

### Field of the Invention

The present invention is directed to environmentally friendly stable catalysts for electroless metallization of printed circuit boards and through-holes which include a maltodextrin stabilizer and nanoparticles of catalytic metal at certain molar ratios and are tin free. More specifically, the present invention is directed to environmentally friendly stable catalysts for electroless metallization of printed circuit boards and through-holes which include a maltodextrin stabilizer and nanoparticles of catalytic metal at certain molar ratios and are tin free to stabilize the catalyst during storage as well as during electroless plating and the catalysts adhere well to dielectric materials of printed circuit boards to enable smooth and uniform metal deposits on board surfaces and on the walls of through-holes.

### Background of the Invention

Printed circuit boards (PCBs) include laminated non-conductive dielectric materials that rely on drilled and plated through-holes (PTHs) to form connections between the opposite sides and innerlayers of the board. Electroless plating is a well-known process for preparing metallic coatings on surfaces. Electroless plating of a dielectric surface requires the prior application of a catalyst to the substrate to be plated. The most commonly used method to catalyze or activate laminated non-conductive dielectric substrate regions, prior to electroless plating, is to treat the substrate with an aqueous tin-palladium colloid in an acidic chloride medium. The colloid consists of a palladium core surrounded by a stabilizing layer of tin (II) ions in the form of a shell of [SnCl₃⁻] complexes, which act as surface stabilizing groups to avoid agglomeration of colloids in suspension.

In the activation process the tin/palladium colloid catalyst is adsorbed onto a dielectric substrate, such as epoxy or polyimide containing substrate, to activate electroless metal deposition. Theoretically the catalyst functions as a carrier in the path of electron transfer from reducing agents to metal ions in the electroless metal plating bath. Although performance of electroless plating is influenced by many factors, such as additive composition of the plating solution, the activation step is key for controlling the rate and mechanism of electroless plating.

In recent years, along with the reduction in size and desired increase in the performance of electronic devices, the demand for defect free electronic circuits in the electronic packaging industry has become higher. Although the tin/palladium colloid has been commercially used as an activator for electroless metal plating for decades and has given acceptable service, it has many disadvantages which are becoming more pronounced as the demand for higher quality electronic devices increases. The stability of the tin/palladium colloid is a major concern. As mentioned above the tin/palladium colloid is stabilized by a layer of tin(II) ions and its counter anions can prevent palladium from agglomerating. The catalyst is sensitive to air and readily oxidizes to tin(IV), thus the colloid cannot maintain its colloidal structure. This oxidation is further promoted by increase in temperature and agitation during electroless plating. If the concentration of tin(II) falls to critical levels, such as close to zero, palladium metal particles grow in size, agglomerate and precipitate, thus becoming catalytically inactive. As a result there is an increase in demand for a more stable catalyst. In addition the high and fluctuating cost of palladium has encouraged the industry to search for a less costly metal.

Considerable efforts have been made to find new and improved catalysts. Because of the high cost of palladium, much effort has been directed toward development of palladium free catalysts, such as colloidal silver catalysts. Another direction that research has taken is towards a tin free palladium catalyst since stannous chloride is costly and the oxidized tin requires a separate acceleration step. In addition to adding a further step in the overall electroless process, materials used in the acceleration step often strip the catalyst from the substrate to be plated leaving undesirable voids in the plating. This is especially common on glass fiber substrates which are typically used in printed circuit board manufacturing. However, such tin free catalysts have shown to be insufficiently active and reliable for through-hole plating in printed circuit board manufacture. Further, such catalysts typically become progressively less active upon storage, thus rendering such catalysts unreliable and impractical for commercial use.

Alternative stabilizing moieties for tin complexes, such as polyvinylpyrrolidone (PVP) and dendrimers, have been investigated. Stable and uniform PVP protected nanoparticles have been reported by various research groups in the literature. Other metal colloids, such as silver/palladium and copper/palladium in which palladium is partially replaced by less expensive metals also have been reported in the literature; however, to date there has been no commercially acceptable alternative for the tin/palladium colloidal catalyst. Accordingly, there is still a need for a stable and reliable electroless metal plating catalyst.

### Summary of the Invention

A method of electroless plating comprising: providing a substrate; applying an aqueous catalyst solution to the substrate, the aqueous catalyst solution comprises nanoparticles of one or more metals chosen from silver, gold, platinum, palladium, iridium, copper, aluminum, cobalt, nickel and iron, a maltodextrin and a reducing agent selected from the groups consisting of glucose, sucrose, galactose, fructose, maltose and mixtures thereof, wherein a weight ratio of the dextrin to reducing agent is 100:1 to 1:5, the aqueous catalyst solution is free of tin; contacting the catalyzed substrate with an electroless metal plating bath; and electrolessly depositing metal on the catalyzed substrate with the electroless metal plating bath.

The catalysts can be used to electrolessly plate metals on substrates, including substrates having metal surfaces and those having dielectric materials. The catalysts of the present invention are stable upon storage as well as during electroless metal plating. They do not readily oxidize as compared to conventional tin/palladium catalysts. In addition, the catalysts adhere well to substrate surfaces and aperture walls which can be metal, dielectric materials or combinations thereof. Good adhesion of the catalysts of the present invention to the substrate as well as the stability of the catalysts of the present invention on the substrate enable electrolessly plated metals to form uniform and planar metal deposits on substrates. The catalysts of the present invention also enable uniform, planar and conformal metal plating on walls and knees of apertures. The catalysts are typically used in the formation of flash or strike layers on the surface and walls of apertures prior to electrolytic metal plating, such as copper electroplating. The strike layers formed with the catalysts of the present invention assist in enabling the formation of uniform and substantially complete filling of apertures such as through-holes in printed circuit boards during electrolytic metal plating.

The maltodextrin stabilizer in combination with the carbohydrate reducing agents of the catalysts not only enable the catalysts to adhere well to substrates but are biodegradable, thus they do not present an environmental hazard. In addition, the catalysts of the present invention are tin free and do not raise the environmentally toxic disposal issue of conventional tin/palladium catalysts.

### Detailed Description of the Invention

As used throughout this specification the following abbreviations shall have the following meanings unless the context clearly indicates otherwise: A = amperes; A/dm² = amperes per square decimeter; °C = degrees Centigrade; g = gram; mg = milligrams; ppm = parts per million; ppm = mg/L; L = liter, nm = nanometers; µm = micron = micrometer; mm = millimeters; cm = centimeters; b.v. = by volume; DI = deionized; mL = milliliter; Mw = weight average molecular weight; All amounts are percent by weight, unless otherwise noted. All numerical ranges are inclusive and combinable in any order, except where it is clear that such numerical ranges are constrained to add up to 100%.

As used throughout the specification, "feature" refers to the geometries on a substrate. "Aperture" refers to recessed features including through-holes and blind vias. As used throughout this specification, the term "plating" refers to metal electroless plating unless designated otherwise. The term "planar" refers to a surface which is substantially flat with a uniform surface topography. "Deposition" and "plating" are used interchangeably throughout this specification. The terms "printed circuit boards" and "printed wiring boards" are used interchangeably throughout this specification. The indefinite articles "a" and "an" represent both the singular and the plural.

Aqueous catalyst solutions include nanoparticles of metals chosen from silver, gold, platinum, palladium, iridium, copper, aluminum, cobalt, nickel and iron, one or more stabilizing maltodextrins and a reducing agent selected from the group consisting of glucose, sucrose, galactose, fructose, maltose and mixtures thereof. Preferably the metals are chosen from silver, gold and copper, more preferably the metals are chosen from silver and copper, most preferably the metal is silver. Preferably, the maltodextrin stabilizing compounds have a general formula: 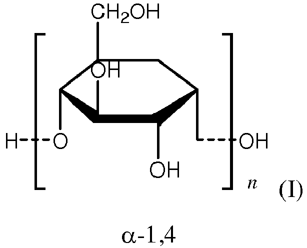 where "*n*" is a number such that 2 < *n* < 20.

The stabilizing maltodextrin compounds and reducing agents are included in the aqueous catalysts in sufficient amounts to provide the desired stabilization and electroless metal plating. Preferably the stabilizing maltodextrin compounds and reducing agents are at weight ratios where the maltodextrin to the reducing agent is 100:1 to 1:5, more preferably from 60:1 to 1:2 and most preferably from 30:1 to 1:1. Minor experimentation may be done to achieve the amount of a particular maltodextrin stabilizer or combination of maltodextrin stabilizers to reducing agents to stabilize a catalyst for electroless metal plating. In general, one or more stabilizing compounds are included in the aqueous catalyst in amounts of 50 ppm to 1000 ppm. In general, reducing agents are included in amounts of 10 ppm to 250 ppm.

Optionally, one or more antioxidants are included in the catalysts. Such antioxidants include, but are not limited to organic acids such as mono-carboxylic acids and polycarboxylic acids. Examples of such acids include benzoic acid and its derivatives, ascorbic acid, isoascorbic acid, malic acid, acetic acid, tartaric acid, Rochelle salts and citric acid. Such acids are included in amounts of 10 ppm to 200 ppm, preferably from 20 ppm to 100 ppm.

Sources of metals include any of the conventional water soluble metal salts known in the art and literature which provide metals having catalytic activity. Mixtures of two or more catalytic metals may be used. Such salts are included to provide metal in amounts of 100 ppm to 2000 ppm, preferably from 300 ppm to 1500 ppm. Silver salts include, but are not limited to, silver nitrate, silver acetate, silver trifluoroacetate, silver tosylate, silver triflate, silver fluoride, silver oxide, silver sodium thiosulfate and silver potassium cyanide. Palladium salts include, but are not limited to, palladium chloride, palladium acetate, palladium potassium chloride, palladium sodium chloride and palladium nitrate. Gold salts include, but are not limited to gold cyanide, gold trichloride, gold tribromide, potassium gold chloride, potassium gold cyanide, sodium gold chloride and sodium gold cyanide. Platinum salts include, but are not limited to, platinum chloride and platinum sulfate. Iridium salts include, but are not limited to, iridium tribromide and iridium potassium chloride. Copper salts include, but are not limited to, copper sulfate and copper chloride. Nickel salts include, but are not limited to nickel chloride and nickel sulfate. Cobalt salts include, but are not limited to, cobalt acetate, cobalt chloride, cobalt bromide and cobalt ammonium sulfate. Aluminum salts include, but are not limited to, aluminum sulfate and aluminum sodium sulfate. Iron salts include, but are not limited to, ferrous ammonium citrate, ferrous ammonium oxalate and ferrous ammonium sulfate. Preferably the metal salts are silver, copper and gold. More preferably the metal salts are silver and copper. Most preferably the salts are silver.

The components which make up the aqueous catalyst may be combined in any order. Any suitable method known in the art and literature can be used to prepare the aqueous catalyst. While the specific parameters and amounts of components may vary from one method to the other, in general, one or more of the stabilizing compounds is first solubilized in a sufficient amount of water. Optionally, the aqueous solution can be heated to help solubilize the dextrin stabilizer. One or more sources of metal as an aqueous solution are combined with the stabilizer solution with vigorous agitation to form a uniform mixture. An aqueous solution containing one or more reducing agents is then mixed with the mixture of stabilizers and metal salts also with vigorous agitation. While not being bound by theory, the stabilizers may coat or surround portions or most of the metal to stabilize the catalyst solution. The diameters of the particles of metal and stabilizer are from at least 1 nm, typically from 1 nm to 1000 nm or such as from 2nm to 500nm. Preferably the particles range in size from 2 nm to 300 nm, more preferably from 2 nm to 100 nm and most preferably from 2 nm to 10 nm.

The pH of the as-synthesized catalyst may range from acidic to mildly alkaline. If the catalyst is alkaline, prior to using the catalyst for electroless metallization, the pH is reduced to below 7. One or more acids or salts thereof may be added to the catalyst to provide a pH range of less than 7, preferably from 1-6.5, more preferably from 2-6. Inorganic or organic acids or salts thereof may be used in sufficient amounts to maintain the pH at the desired range. Mixtures of inorganic and organic acids and salts also may be used. Examples of inorganic acids are hydrochloric acid, sulfuric acid and nitric acid. Organic acids include mono- and polycarboxylic acids, such as dicarboxylic acids. Examples of organic acids are benzoic acid, ascorbic acid, isoascorbic acid, malic acid, maleic acid, oxalic acid, acetic acid, citric acid and tartaric acid.

The catalysts may be used to electrolessly metal plate various substrates. Such substrates include, but are not limited to, materials including inorganic substances such as metals, glass, ceramics and porcelain, and organic substances such as resins, paper and cloth. Metal-clad and unclad materials also are substrates which may be metal plated using the catalyst.

Substrates also include printed circuit boards. Such printed circuit boards include metal-clad and unclad with thermosetting resins, thermoplastic resins and combinations thereof, including fiber, such as fiberglass, and impregnated embodiments of the foregoing.

Thermoplastic resins include, but are not limited to, acetal resins, acrylics, such as methyl acrylate, cellulosic resins, such as ethyl acetate, cellulose propionate, cellulose acetate butyrate and cellulose nitrate, polyethers, nylon, polyethylene, polystyrene, styrene blends, such as acrylonitrile styrene and copolymers and acrylonitrile-butadiene styrene copolymers, polycarbonates, polychlorotrifluoroethylene, and vinylpolymers and copolymers, such as vinyl acetate, vinyl alcohol, vinyl butyral, vinyl chloride, vinyl chloride-acetate copolymer, vinylidene chloride and vinyl formal.

Thermosetting resins include, but are not limited to, allyl phthalate, furane, melamine-formaldehyde, phenol-formaldehyde and phenol-furfural copolymers, alone or compounded with butadiene acrylonitrile copolymers or acrylonitrile-butadiene-styrene copolymers, polyacrylic esters, silicones, urea formaldehydes, epoxy resins, allyl resins, glyceryl phthalates and polyesters.

Porous materials include, but are not limited to paper, wood, fiberglass, cloth and fibers, such as natural and synthetic fibers, such as cotton fibers and polyester fibers.

The catalysts may be used to plate both low and high T_{g} resins. Low T_{g} resins have a T_{g} below 160° C and high T_{g} resins have a T_{g} of 160° C and above. Typically high T_{g} resins have a T_{g} of 160° C to 280° C or such as from 170° C to 240° C. High T_{g} polymer resins include, but are not limited to, polytetrafluoroethylene (PTFE) and polytetrafluoroethylene blends. Such blends include, for example, PTFE with polypheneylene oxides and cyanate esters. Other classes of polymer resins which include resins with a high Tg include, but are not limited to, epoxy resins, such as difunctional and multifunctional epoxy resins, bimaleimide/triazine and epoxy resins (BT epoxy), epoxy/polyphenylene oxide resins, acrylonitrile butadienestyrene, polycarbonates (PC), polyphenylene oxides (PPO), polypheneylene ethers (PPE), polyphenylene sulfides (PPS), polysulfones (PS), polyamides, polyesters such as polyethyleneterephthalate (PET) and polybutyleneterephthalate (PBT), polyetherketones (PEEK), liquid crystal polymers, polyurethanes, polyetherimides, epoxies and composites thereof.

The catalyst may be used to deposit metals on the walls of through-holes or vias of printed circuit boards. The catalysts may be used in both horizontal and vertical processes of manufacturing printed circuit boards.

The aqueous catalysts may be used with conventional electroless metal plating baths. While it is envisioned that the catalysts may be used to electrolessly deposit any metal which may be electrolessly plated, typically, the metal is chosen from copper, copper alloys, nickel or nickel alloys. More typically the metal is chosen from copper and copper alloys, most typically copper is used. An example of a commercially available electroless copper plating bath is CIRCUPOSIT™ 880 Electroless Copper bath (available from Dow Electronic Materials, LLC, Marlborough, MA).

Typically sources of copper ions include, but are not limited to, water soluble halides, nitrates, acetates, sulfates and other organic and inorganic salts of copper. Mixtures of one or more of such copper salts may be used to provide copper ions. Examples include copper sulfate, such as copper sulfate pentahydrate, copper chloride, copper nitrate, copper hydroxide and copper sulfamate. Conventional amounts of copper salts may be used in the compositions. In general copper ion concentrations in the composition may range from 0.5 g/L to 30 g/L.

One or more alloying metals also may be included in the electroless compositions. Such alloying metals include, but are not limited to, nickel and tin. Examples of copper alloys include copper/nickel and copper/tin. Typically the copper alloy is copper/nickel.

Sources of nickel ions for nickel and nickel alloy electroless baths may include one or more conventional water soluble salts of nickel. Sources of nickel ions include, but are not limited to, nickel sulfates and nickel halides. Sources of nickel ions may be included in the electroless alloying compositions in conventional amounts. Typically sources of nickel ions are included in amounts of 0.5 g/L to 10 g/L.

The method steps used in metalizing a substrate may vary depending on whether the surface to be plated is metal or dielectric. Specific steps and sequence of steps may also vary from one method to the next. Conventional steps used for electrolessly metal plating a substrate may be used with the catalysts; however, the aqueous stabilized metal catalysts do not require an acceleration step as in many conventional electroless plating processes. Accordingly, acceleration steps are preferably excluded when using the catalyst. In general, the catalyst is applied to the surface of the substrate to be electrolessly plated with a metal followed by application of the metal plating bath. Electroless metal plating parameters, such as temperature and time may be conventional. Conventional substrate preparation methods, such as cleaning or degreasing the substrate surface, roughening or micro-roughening the surface, etching or micro-etching the surface, solvent swell applications, desmearing through-holes and various rinse and anti-tarnish treatments can be used. Such methods and formulations are well known in the art and disclosed in the literature.

Typically, when the substrate to be metal plated is a dielectric material such as on the surface of a printed circuit board or on the walls of through-holes, the boards are rinsed with water and cleaned and followed by desmearing the through-hole walls. Typically prepping or softening the dielectric surface or desmearing of the through-holes begins with application of a solvent swell.

Any conventional solvent swell may be used. The specific type may vary depending on the type of dielectric material. Examples of dielectrics are disclosed above. Minor experimentation may be done to determine which solvent swell is suitable for a particular dielectric material. The T_{g} of the dielectric often determines the type of solvent swell to be used. Solvent swells include, but are not limited to, glycol ethers and their associated ether acetates. Conventional amounts of glycol ethers and their associated ether acetates may be used. Examples of commercially available solvent swells are CIRCUPOSIT™ Hole Prep 211A, CIRCUPOSIT™ Hole Prep 3303 and CIRCUPOSIT™ Hole Prep 4120 (available from Dow Electronic Materials).

Optionally, the substrate and through-holes are rinsed with water. A promoter is then applied. Conventional promoters may be used. Such promoters include sulfuric acid, chromic acid, alkaline permanganate or plasma etching. Typically alkaline permanganate is used as the promoter. An example of a commercially available promoter is CIRCUPOSIT™ Promoter 4130 and CIRCUPOSIT™ MLB Promoter 3308 (available from Dow Electronic Materials).

Optionally, the substrate and through-holes are rinsed again with water. A neutralizer is then applied to neutralize any residues left by the promoter. Conventional neutralizers may be used. Typically the neutralizer is an aqueous acidic solution containing one or more amines or a solution of 3wt% peroxide and 3wt% sulfuric acid. An example of a commercially available neutralizer is CIRCUPOSIT™ MLB Neutralizer 216-5. The substrate and through-holes are rinsed with water and can either remain wet or dried.

After the desmearing process an acid or alkaline conditioner is applied. Conventional conditioners may be used. Such conditioners may include one or more cationic surfactants, nonionic surfactants, complexing agents and pH adjusters or buffers. Examples of commercially available acid conditioners are CIRCUPOSIT™ Conditioner 3320A and CIRCUPOSIT™ Conditioner 3327 (available from Dow Electronic Materials). Suitable alkaline conditioners include, but are not limited to, aqueous alkaline surfactant solutions containing one or more quaternary amines and polyamines. Examples of commercially available alkaline surfactants are CIRCUPOSIT™ Conditioner 231, 3325, 813 and 860. After conditioning the substrate and through-holes are rinsed with water.

Conditioning can be followed by micro-etching. Conventional micro-etching compositions may be used. Micro-etching is designed to provide a micro-roughened metal surface on exposed metal (e.g. innerlayers and surface etch) to enhance subsequent adhesion of deposited electroless and later electroplate. Micro-etches include, but are not limited to, 10 g/L to 200 g/L sodium persulfate or sodium or potassium oxymonopersulfate and sulfuric acid (1-5%) mixture, or generic sulfuric acid/hydrogen peroxide. Examples of commercially available micro-etching compositions are CIRCUPOSIT™ Microetch 3330 and PREPOSIT™ 748. Optionally, the substrate is rinsed with water.

Optionally, a pre-dip may then applied to the micro-etched substrate and through-holes. Inorganic or organic acids or salts thereof may be used in sufficient amounts. Mixtures of inorganic and organic acids and salts also may be used. Examples of inorganic acids are hydrochloric acid, sulfuric acid and nitric acid. Organic acids include mono- and polycarboxylic acids, such as dicarboxylic acids. Examples of organic acids are benzoic acid, ascorbic acid, isoascorbic acid, malic acid, maleic acid, oxalic acid, acetic acid, citric acid and tartaric acid.

A maltodextrin stabilized catalyst is then applied to the substrate and through-holes. Dwell times in the catalyst can range from 1-15 minutes 1-10 minutes, typically from 2-8 minutes. Temperatures may range from room temperature to 80° C, or such as from 30° C to 60° C. The substrate and through-holes are rinsed with water after application of the catalyst.

The substrate and walls of the through-holes are then plated with metal, such as copper, copper alloy, nickel or nickel alloy with an electroless bath. Typically copper is plated on the substrate surface and walls of the through-holes. Plating times and temperatures may be conventional. Typically metal deposition is done at temperatures of 20° C to 80° C, more typically from 30° C to 60° C. The substrate may be immersed in the electroless plating bath or the electroless may be sprayed onto the substrate. Typically, deposition may be done for 5 seconds to 30 minutes; however, plating times may vary depending on the thickness of the metal on the substrate.

Optionally anti-tarnish may be applied to the metal. Conventional anti-tarnish compositions may be used. An example of anti-tarnish is ANTI TARNISH™ 7130 (obtainable from Dow Electronic Materials). The substrate may optionally be rinsed and then the boards may be dried.

Further processing may include conventional processing by photoimaging and further metal deposition on the substrates such as electrolytic metal deposition of, for example, copper, copper alloys, tin and tin alloys.

The catalysts may be used to electrolessly plate metals on substrates, including substrates of dielectric materials and are stable upon storage, and during electroless metal plating. The catalysts are biodegradable, thus they do not present an environmental hazard. The maltodextrin stabilized metal catalysts enable electroless metal plating without an acceleration step and enable metal plating of the substrate, even walls of through-holes of printed circuit boards.

The following examples are not intended to limit the scope of the invention but are intended to further illustrate it.

### Example 1

### Maltodextrin/Silver Catalyst Synthesis with Glucose as Reducing Agent

A maltodextrin/silver catalyst was prepared by dissolving 3 grams of maltodextrin in a beaker containing 900 mL DI water at room temperature. 472 mg of silver nitrate was added to 50 mL of DI water and the mixture was vigorously stirred until it completely dissolved. The silver nitrate mixture was added to the maltodextrin solution and vigorously stirred while continuously heating. The pH was adjusted to 9-13 and 100 mg of glucose was dissolved in 20 mL of DI water and added to the solution mixture with very vigorous agitation. The solution quickly changed from colorless to reddish brown indicating reduction of the silver ions to silver metal. The final volume was then adjusted to one liter. The solution pH was re-adjusted with an inorganic or organic acid and the as-synthesized catalyst had a pH of 5 to 10 as measured using an ACCUMET AB 15 pH meter. The beaker containing the aqueous catalyst solution was placed in a 50 °C water bath for about 12 hours to test its stability. After about 12 hours there was no observable precipitate indicating that the catalyst was still stable.

### Example 2

### Electroless Copper Plating

The catalyst solution prepared in Example 1 was used as a stock solution and 2 aliquots were diluted with DI water to nanoparticle concentrations of 250 ppm. The pH of the aliquots was adjusted to either 3 or 5 with ascorbic acid. The weight ratio of the maltodextrin to the reducing agent was about 30:1.

Two bare laminate coupons having dimensions 10 cm x 5 cm were conditioned with a 3% b.v. CIRCUPOSIT™ Conditioner 231 and rinsed with tap water at room temperature. Each coupon was then immersed in one of the two aliquots containing the maltodextrin/silver catalyst for about 5 minutes to prime each coupon with the catalysts. The aqueous catalyst baths with the coupons were heated during catalization at a temperature of about 40 °C. The catalyzed coupons were then immersed in CIRCUPOSIT™ 880 electroless copper plating baths at 36 °C for about 15 minutes. The pH of the electroless copper plating baths was about 12.

The coupons were removed from the electroless copper baths and rinsed with deionized water at room temperature. Both coupons appeared to be completely plated with copper. The copper deposit appeared smooth, uniform and planar over all the surfaces of the coupons. Adhesion of the copper deposit was tested using the 3M 250 tape test as per ASTM D3359. Tape was applied to one surface of each coupon and the tape was pulled from the coupon. No copper deposit was observed on the tape indicating good copper adhesion to each coupon.

### Example 3

### Through-Hole Plating

Six different laminates with a plurality of through-holes were provided: NP-175, 370 HR, TUC-752, SY-1141, SY-1000-2, and FR-408. The NP-175 was from Nan Ya. The 370 HR and FR4-408 were from Isola. TUC-752 was from Taiwan Union Technology, and SY-1141 and SY-1000-2 were from Shengyi. The T_{g} values of the laminates ranged from 140° C to 180° C. Each laminate was 5cm x 12cm. The through-holes of each laminate were treated as follows:
1. The through-holes of each laminate were desmeared with CIRCUPOSIT™ MLB Conditioner 211 for 7 minutes at 78° C;
2. The through-holes of each laminate were then rinsed with flowing tap water for 4 minutes;
3. The through-holes were then treated with CIRCUPOSIT™ MLB Promoter 213 aqueous permanganate solution at a pH of 13 at 78° C for 10 minutes;
4. The through-holes were then rinsed for 4 minutes in flowing tap water;
5. The through-holes were then treated with CIRCUPOSIT™ MLB Neutralizer 216-5 solution for 5 minutes at 46° C;
6. The through-holes of each laminate were then rinsed with flowing tap water for 4 minutes;
7. The through-holes were then treated in an aqueous bath containing 3% CIRCUPOSIT™ Conditioner 231 alkaline conditioner for 5 minutes at 40° C;
8. The through-holes of each laminate were then rinsed with flowing tap water for 4 minutes;
9. The through-holes were then treated with PREPOST™ 748 for 2 minutes at room temperature;
10. The through-holes of each laminate were then rinsed with flowing tap water for 4 minutes;
11. Through-holes of the six laminates were then primed for 5 minutes at 40° C with a 300 ppm silver catalyst from silver nitrate stabilized with 200 ppm of maltodextrin with catalyst particle sizes ranging from 7-10 nm. The reducing agent was 200 ppm of glucose. The pH of the catalyst was adjusted to about 3 with ascorbic acid;
12. The through-holes were then rinsed with flowing tap water for 4 minutes;
13. The laminates were then immersed in CIRCUPOSIT™ 880 electroless copper plating bath at 40° C and at a pH of about 13 and copper was deposited on the walls of the through-holes for 15 minutes;
14. The copper plated laminates were then rinsed with cold water for 4 minutes;
15. Each copper plated laminate was then dried with compressed air; and
16. The walls of the through-holes of the laminates were examined for copper plating coverage using the backlight process described below.

Each board was sectioned laterally to expose the copper plated walls of the through-holes. Ten lateral holes which were approximately 1 mm thick were taken from each board to determine the through-hole wall coverage. A universally accepted Backlight Grading Scale was used. The 1 mm sections from each board were placed under a conventional optical microscope of 50X magnification. The quality of the copper deposits was determined by the amount of light that was observed under the microscope. If no light was observed the section was completely black and was rated a 5 on the backlight scale indicating complete copper coverage of the through-hole wall. If light passed through the entire section without any dark areas, this indicated that there was very little to no copper metal deposition on the wall and the section was rated 0. If sections have some dark regions as well as light regions, they were rated between 0 and 5.

With the exception of the NP-175 board, the maltodextrin/silver catalyst had average backlight values of 4.5 and greater. Typically backlight values of 4.5 and greater were indicative of commercially acceptable catalysts in the plating industry.

### Example 4

### Maltodextrin/Silver Catalyst Synthesis with Sucrose as Reducing Agent

A maltodextrin/silver catalyst was prepared by dissolving 3 grams of maltodextrin in a beaker containing 1000 mL DI water with heating at 50 °C to 55 °C. 472 mg of silver nitrate was added to 50 mL of DI water and mixed until it completely dissolved. The mixture was added to the solution and vigorously stirred while continuously heating. The pH was adjusted to 9-13 and 100 mg of sucrose dissolved in 20 mL of DI water. The DI water was added to the solution mixture with very vigorous agitation. The solution quickly changed from colorless to reddish brown indicating reduction of the silver ions to silver metal. The final volume was then adjusted to one liter. The solution pH was re-adjusted with an organic acid and the as-synthesized catalyst had a pH of around 5-10 as measured using an ACCUMET AB15 pH meter. The beaker containing the aqueous catalyst solution was placed in a 50 °C water bath for about 12 hours to test its stability. After about 12 hours there was no observable precipitate indicating that the catalyst was still stable.

### Example 5

### Electroless Copper Plating

The catalyst solution prepared in Example 1 was used as a stock solution and 2 aliquots were diluted with DI water to nanoparticle concentrations of 250 ppm. The pH of the aliquots was adjusted to either 3 or 5 with ascorbic acid. The weight ratio of the maltodextrin to the reducing agent was about 30:1.

Two bare laminate coupons having dimensions 10 cm x 5 cm were conditioner with a 3% b.v. CIRCUPOSIT™ Conditioner 231 and rinsed with tap water at room temperature. Each coupon was then immersed in one of the two aliquots containing the maltodextrin/silver catalyst for about 5 minutes to prime each coupon with the catalysts. The aqueous catalyst baths with the coupons were heated during catalization at a temperature of about 40 °C. The catalyzed coupons were then immersed in CIRCUPOSIT™ 880 electroless copper plating baths at 36 °C for about 15 minutes. The pH of the electroless copper plating baths was about 12.

The coupons were removed from the electroless copper baths and rinsed with deionized water at room temperature. Both coupons appeared to be completely plated with copper. The copper deposit appeared smooth, uniform and planar over all the surfaces of the coupons. Adhesion of the copper deposit was tested using the 3M 250 tape test as per ASTM D3359. Tape was applied to one surface of each coupon and the tape was pulled from the coupon. No copper deposit was observed on the tape indicating good copper adhesion to each coupon.

### Example 6

### Maltodextrin/Silver Catalyst Synthesis with Galactose as Reducing Agent

A maltodextrin/silver catalyst was prepared by dissolving 3 grams of maltodextrin in a beaker containing 1000 mL DI water with heating at 50 °C to 55 °C. 472 mg of silver nitrate was added to 50 mL of DI water and mixed until it was completely dissolved. The mixture was added to the solution and vigorously stirred while continuously heating. The pH was adjusted to 9-13 and 100 mg of galactose was dissolved in 20 mL of DI water and was added to the solution mixture with very vigorous agitation. The solution quickly changed from colorless to reddish brown indicating reduction of the silver ions to silver metal. The final volume was then adjusted to one liter. The solution pH was re-adjusted with an organic acid and the as-synthesized catalyst had a pH of around 5-10 as measured using an ACCUMET AB15 pH meter. The beaker containing the aqueous catalyst solution was placed in a 50 °C water bath for about 12 hours to test its stability. After about 12 hours there was no observable precipitate indicating that the catalyst was still stable.

### Example 7

### Electroless Copper Plating

The catalyst solution prepared in Example 1 was used as a stock solution and 2 aliquots were diluted with DI water to nanoparticle concentrations of 250 ppm. The pH of the aliquots was adjusted to either 3 or 5 with ascorbic acid. The weight ratio of the dextrin to the reducing agent was about 30:1.

Two bare laminate coupons having dimensions 10 cm x 5 cm were conditioned with a 3% b.v. CIRCUPOSIT™ Conditioner 231 and rinsed with tap water at room temperature. Each coupon was then immersed in one of the two aliquots containing the maltodextrin/silver catalyst for about 5 minutes to prime each coupon with the catalysts. The aqueous catalyst baths with the coupons were heated during catalization at a temperature of about 40 °C. The catalyzed coupons were then immersed in CIRCUPOSIT™ 880 electroless copper plating baths at 36 °C for about 15 minutes. The pH of the electroless copper plating baths was about 12.

The coupons were removed from the electroless copper baths and rinsed with deionized water at room temperature. Both coupons appeared to be completely plated with copper. The copper deposit appeared smooth, uniform and planar over all the surfaces of the coupons. Adhesion of the copper deposit was tested using the 3M 250 tape test as per ASTM D3359. Tape was applied to one surface of each coupon and the tape was pulled from the coupon. No copper deposit was observed on the tape indicating good copper adhesion to each coupon.

### Example 8

### Maltodextrin/Silver Catalyst Synthesis with Fructose as Reducing Agent

A maltodextrin/silver catalyst was prepared by dissolving 3 grams of maltodextrin in a beaker containing 1000 mL DI water with heating at 50 °C to 55 °C. 472 mg of silver nitrate was added to 50 mL of DI water and mixed until it was completely dissolved. The mixture was added to the solution and vigorously stirred while continuously heating. The pH was adjusted to 9-13 and 100 mg of fructose dissolved in 20 mL of DI water and is added to the solution mixture with very vigorous agitation. The solution quickly changed from colorless to reddish brown indicating reduction of the silver ions to silver metal. The final volume was then adjusted to one liter. The solution pH was re-adjusted with an organic acid and the of the as-synthesized catalyst had a pH of around 5-10 as measured using an ACCUMET AB15 pH meter. The beaker containing the aqueous catalyst solution was placed in a 50 °C water bath for about 12 hours to test its stability. After about 12 hours there was no observable precipitate indicating that the catalyst was still stable.

### Example 9

### Electroless Copper Plating

The catalyst solution prepared in Example 1 was used as a stock solution and 2 aliquots were diluted with DI water to nanoparticle concentrations of 250 ppm. The pH of the aliquots was adjusted to either 3 or 5 with ascorbic acid. The weight ratio of the maltodextrin to the reducing agent was about 30:1.

Two bare laminate coupons having dimensions 10 cm x 5 cm were conditioner with a 3% b.v. CIRCUPOSIT™ Conditioner 231 and rinsed with tap water at room temperature. Each coupon was then immersed in one of the two aliquots containing the maltodextrin/silver catalyst for about 5 minutes to prime each coupon with the catalysts. The aqueous catalyst baths with the coupons were heated during catalization at a temperature of about 40 °C. The catalyzed coupons weare then immersed in CIRCUPOSIT™ 880 electroless copper plating baths at 36 °C for about 15 minutes. The pH of the electroless copper plating baths was about 12.

The coupons were removed from the electroless copper baths and rinsed with deionized water at room temperature. Both coupons appeared to be completely plated with copper. The copper deposit appeared smooth, uniform and planar over all the surfaces of the coupons. Adhesion of the copper deposit was tested using the 3M 250 tape test as per ASTM D3359. Tape was applied to one surface of each coupon and the tape was pulled from the coupon. No copper deposit was observed on the tape indicating good copper adhesion to each coupon.

### Example 10

### Maltodextrin/Silver Catalyst Synthesis with Maltose as Reducing Agent

A maltodextrin/silver catalyst was prepared by dissolving 3 grams of maltodextrin in a beaker containing 1000 mL DI water with heating at 50 °C to 55 °C. 472 mg of silver nitrate was added to 50 mL of DI water and mixed until it completely dissolved. The mixture was added to the solution and vigorously stirred while continuously heating. The pH was adjusted to 9-13 and 100 mg of maltose dissolved in 20 mL of DI water was added to the solution mixture with very vigorous agitation. The solution quickly changed from colorless to reddish brown indicating reduction of the silver ions to silver metal. The final volume was then adjusted to one liter. The solution pH was re-adjusted with an organic acid and the of the as-synthesized catalyst had a pH of around 5-10 as measured using an ACCUMET AB15 pH meter. The beaker containing the aqueous catalyst solution wais placed in a 50 °C water bath for about 12 hours to test its stability. After about 12 hours there was no observable precipitate indicating that the catalyst was still stable.

### Example 11

### Electroless Copper Plating

The catalyst solution prepared in Example 1 was used as a stock solution and 2 aliquots were diluted with DI water to nanoparticle concentrations of 250 ppm. The pH of the aliquots was adjusted to either 3 or 5 with ascorbic acid. The weight ratio of the maltodextrin to the reducing agent is about 30:1.

Two bare laminate coupons having dimensions 10 cm x 5 cm were conditioned with a 3% b.v. CIRCUPOSIT™ Conditioner 231 and rinsed with tape water at room temperature. Each coupon was then immersed in one of the two aliquots containing the dextrin/silver catalyst for about 5 minutes to prime each coupon with the catalysts. The aqueous catalyst baths with the coupons were heated during catalization at a temperature of about 40 °C. The catalyzed coupons were then immersed in CIRCUPOSIT™ 880 electroless copper plating baths at 36 °C for about 15 minutes. The pH of the electroless copper plating baths is about 12.

The coupons were removed from the electroless copper baths and rinsed with DI water at room temperature. The coupons appeared to be completely plated with copper. The copper deposits appeared smooth, uniform and planar.

## Claims

1. A method of electroless plating comprising:
a) providing a substrate;
b) applying an aqueous catalyst solution to the substrate, the aqueous catalyst solution comprises nanoparticles of one or more metal chosen from silver, gold, platinum, palladium, iridium, copper, aluminum, cobalt, nickel and iron, a maltodextrin and a reducing agent selected from the groups consisting of glucose, sucrose, galactose, fructose, maltose and mixtures thereof, wherein a molar ratio of the starch to reducing is 100:1 to 1:5, the aqueous catalyst solution is free of tin;
c) contacting the catalyzed substrate with an electroless metal plating bath; and
d) electrolessly depositing metal on the catalyzed substrate with the electroless metal plating bath.

2. The method of claim 1, wherein the molar ratio of the maltodextrin to the reducing agent is 60:1 to 1:2.

3. The method of claim 2, wherein the molar ratio of the maltodextrin to the reducing agent in 30:1 to 1:1

4. The method of claim 1, wherein the aqueous catalyst solution further comprises one or more antioxidants.

5. The method of claim 1, wherein the substrate comprises a plurality of apertures.

6. The method of claim 1, wherein the electrolessly deposited metal is copper, copper alloy, nickel or nickel alloy.

7. The method of claim 1, wherein the nanoparticles are at least 1nm in diameter.

8. The method of claim 1, wherein the one or more maltodextrin compounds are in amounts of 50ppmto 1000ppm.

9. The method of claim 1, wherein the substrate comprises a plurality of through-holes.

10. The method of claim 1, further comprising applying a conditioner to the substrate.
